# FASCICULE DE BREVET EUROPEEN

(11) **EP 0 356 300 B1**
(45) Date de publication et mention de la délivrance du brevet: **30.11.1994**
(21) Numéro de dépôt: 89402242.5
(22) Date de dépôt: 09.08.1989
(51) Int. Cl.: H01L 23/498, H01L 21/60

(54) **Support de circuit intégré de haute densité et son procédé de fabrication**
Träger einer hoch integrierten Schaltung und Verfahren zur seiner Herstellung
High-density integrated-circuit carrier, and method of manufacturing same

(30) Priorité: 23.08.1988 FR 8811107
(43) Date de publication de la demande: 28.02.1990
(73) Titulaire: BULL S.A., 92800 Puteaux (FR)
(72) Inventeur: Dehaine, Gérard, F-75016 Paris (FR)
(74) Mandataire: Denis, Hervé

(56) Documents cités:
- EP-A- 0 080 041
- EP-A- 0 094 716
- US-A- 3 838 984
- PATENT ABSTRACTS OF JAPAN, vol. 11, no. 209 (E-521)[2656], 7 juillet 1987, page39 E 521; & JP-A-62 30 342

## Description

L'invention se rapporte à un support de circuit intégré de haute densité et à son procédé de fabrication.

Les circuits intégrés de haute densité, couramment appelés puces ou circuits VLSI (Very Large Scale Integration), sont actuellement de fines plaquettes de matériau semiconducteur sensiblement carrées de plus d'un centimètre de côté, pourvues d'un grand nombre de bornes d'entrée-sortie, de l'ordre de 300 à 400. Selon la technologie TAB (Tape-Automated Bonding) chaque circuit intégré est monté sur un support constitué d'un substrat isolant incluant une fenêtre dans laquelle converge un faisceau de conducteurs en porte-à-faux sur le substrat. Les bornes d'entrée-sortie du circuit intégré sont fixées par une opération dite ILB (Inner Lead Bonding) dans la fenêtre du substrat, aux extrémités libres des conducteurs. Ces bornes sont de ce fait placées à la périphérie du circuit intégré, en ligne ou en quinconce. La terminologie courante désigne le support par support TAB, le faisceau des conducteurs par araignée, les conducteurs par pattes de l'araignée et leurs extrémités intérieures par extrémités ILB. Ordinairement, le substrat isolant du support forme un ruban souple de type film cinématographique, pourvu de fenêtres successives pour le montage des circuits intégrés et de perforations latérales pour le déplacement et le positionnment du ruban.

Le pas des bornes d'entrée-sortie sur un circuit intégré de haute densité peut actuellement descendre en-dessous de 100 micromètres. Les pattes d'une araignée destinée à un tel circuit intégré sont donc nécessairement très étroites et très proches les uns des autres. Pour les rigidifier et assurer leur équidistance au cours des diverses manipulations du support et de l'araignée, les pattes à l'intérieur d'une fenêtre sont généralement portées par au moins un cadre isolant issu du substrat du support. Un tel cadre existe actuellement pour porter les extrémités ILB des pattes d'une araignée. Dans un cas, l'opération ILB est faite à proximité du cadre, qui repose sur le circuit intégré. Autrement, le cadre est percé de trous sous les pattes pour leur connexion ILB aux bornes correspondantes du circuit intégré, comme cela est décrit dans le document EP-A- 0 094 716. Dans les deux cas, les pattes se trouvent séparées des bornes correspondantes du circuit intégré d'une hauteur égale à l'épaisseur du cadre ILB. Par conséquent, la connexion ILB est faite généralement par des boules fixées ou déposées sur les bornes d'entrée-sortie du circuit intégré, faites couramment en un matériau de brasage tel que l'étain-plomb et suffisamment hautes pour compenser l'épaisseur du cadre ILB. Le problème posé par ce cadre pour la soudure ILB aux bornes d'un circuit intégré de haute densité a été résolu jusqu'à présent par un procédé sophistiqué de fabrication d'un support TAB.

Un support TAB classique est fait par gravure d'une feuille de cuivre collée sur un substrat préformé. Ce support se compose donc de trois couches : cuivre - adhésif - substrat. Ordinairement, la feuille de cuivre a une épaisseur d'environ 15 à 70 micromètres, la colle est en acrylique ou en époxy étalée sur une épaisseur d'environ 25 micromètres, et le substrat est un film de type cinématographique fait d'un matériau souple et électriquement isolant (par exemple en kapton, mylar, époxy, ...), dont l'épaisseur minimale est d'environ 50 micromètres et couramment de l'ordre de 100 micromètres. Toutes les ouvertures du substrat sont faites par découpage mécanique, tel que le poinçonnage. Le cadre ILB formé par découpage d'une fenêtre dans le substrat est nécessairement porté par celui-ci, en pratique par des bras disposés suivant les diagonales de la fenêtre. Ce support est peu coûteux et a un substrat suffisamment épais pour conserver une rigidité appréciable lorsqu'il est de grande taille, c'est-à-dire supérieur à 50 millimètres de côté. Mais son substrat préformé par découpage mécanique le rend inapplicable aux araignées denses actuelles. En effet, le cadre ILB est formé par découpage du substrat et a ainsi la même épaisseur, soit au minimum 50 micromètres pour obtenir les qualités requises du support. Il s'ensuit que chaque boule de brasure nécessaire pour la fixation d'une patte de l'araignée à la borne correspondante du circuit intégré doit avoir un épaisseur supérieure à l'épaisseur du support, soit plus de 50 micromètres. Ces grosses boules ne peuvent être faites que sur des bornes larges et obligent le percement de trous larges, de sorte qu'elles s'opposent à la haute densité désirée de connexion des pattes sur un circuit intégré. Le percement de trous larges dans un cadre ILB épais ne peut d'ailleurs être fait à échelle industrielle que par poinçonnage, qui a l'inconvénient de percer des trous d'au moins 600 à 800 micromètres de diamètre. L'adaptation d'un support TAB classique à une araignée dense s'est avérée impossible.

La solution actuelle, telle que décrite par exemple dans le document US-A- 3 838 984, réside dans la fabrication d'un support TAB en deux couches : cuivre-substrat. Selon ce procédé, sur un substrat mince d'environ 20 micromètres de matériau isolant - du polyimide ordinairement - on dépose uniformément sous vide une fine pellicule de cuivre (généralement par l'intermédiaire d'une couche d'accrochage, en chrome par exemple) que l'on fait ensuite croître sélectivement par voie électrochimique pour former l'araignée TAB. La pellicule de cuivre est éliminée en dehors du motif de l'araignée et on procède à la gravure du substrat, rendue possible grâce à sa minceur. La gravure consiste par exemple à déposer sur le substrat une pellicule de dioxyde de silicium (SiO2) que l'on grave, grâce à une couche de résine photosensible, pour servir de masque à la gravure par plasma d'oxygène du substrat de polyimide. Le plasma d'oxygène n'attaque que la matière organique, donc la résine photosensible et le polyimide, mais a l'inconvénient d'avoir un temps de pénétration relativement long, de l'ordre d'un micromètre par minute. On comprend que ce procédé ne peut pas s'appliquer industriellement à des substrats épais. Par contre, ce procédé convient très bien aux substrats minces. Dans ce cas, les cadres, et notamment le cadre ILB, n'ont plus besoin d'être rattachés par des bras au reste du substrat. Dans le cas où le cadre ILB doit être percé sous les pattes, les trous sont avantageusement faits lors de la gravure du substrat par le plasma d'oxygène et peuvent ainsi avoir un diamètre inférieur à 100 micromètres. La faible épaisseur du cadre ILB permet la connexion ILB par l'intermédiaire de petites boules de brasure adaptées aux fortes densités des circuits intégrés actuels et les petites perforations gravées dans le cadre ne sont plus des obstacles à la haute intégration souhaitée. Cependant, un tel support coûte environ trois fois plus cher qu'un support classique et son utilisation s'avère délicate pour des substrats larges, de plus de 70 millimètres par exemple, à cause de la trop grande flexibilité du substrat due à sa minceur.

L'invention a pour but d'adapter un support classique, peu coûteux et d'utilisation toujours aisée, aux circuits intégrés actuels de haute densité.

Un support TAB conforme à l'invention est défini par les caractéristiques de la revendication 1.

En corollaire, un procédé conforme à l'invention pour la fabrication du support TAB est défini par les caractéristiques de la revendication 6.

Les caractéristiques et avantages de l'invention ressortiront de la description qui suit, donnée à titre d'exemple et faite en référence aux dessins annexés.

Dans les dessins :
- la figure 1 est une vue de dessus, avec suppression partielle des conducteurs, d'un support TAB conforme à l'invention destiné à un circuit intégré de haute densité ;
- la figure 2 est une vue en coupe partielle selon la ligne II-II du support représenté sur la figure 1, pourvu d'un circuit intégré de haute densité ;
- les figures 3A et 3B sont des vues similaires à celle de la figure 2, illustrant deux étapes antérieures d'un procédé conforme à l'invention de fabrication du support représenté sur les figures 1 et 2 ; et
- la figure 4 est une vue similaire à celle de la figure 2, illustrant une variante de réalisation d'un support TAB conforme à l'invention.

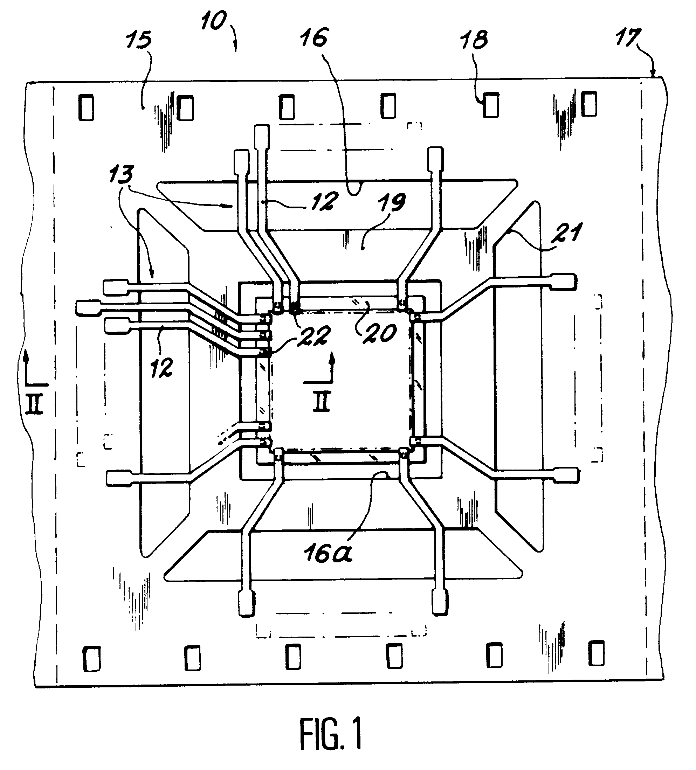

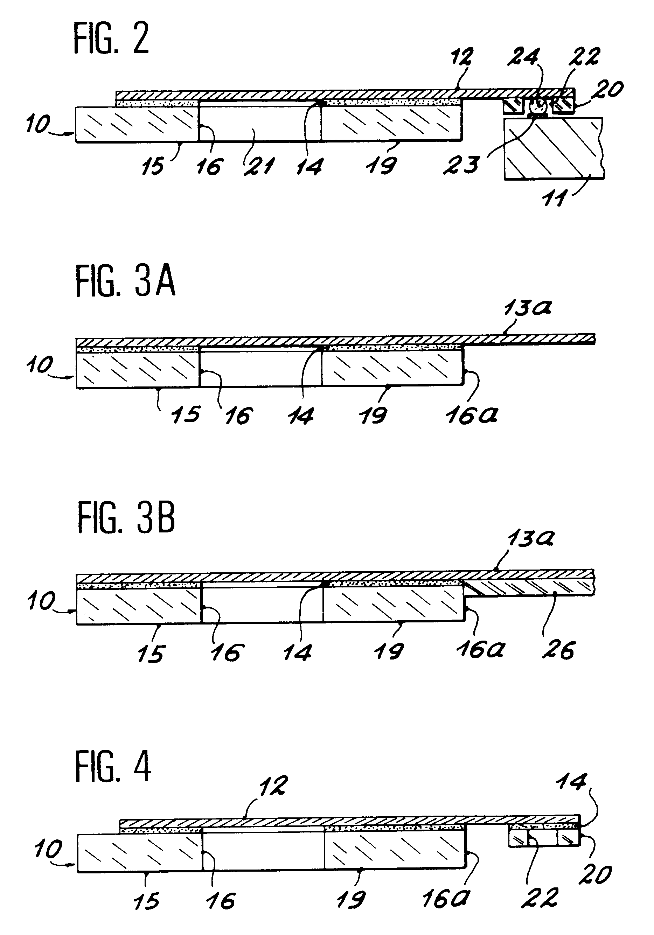

Les figures 1 et 2 illustrent un support TAB 10 conforme à l'invention, adapté à la connexion d'un circuit intégré de haute densité 11. Le support 10 est de type classique, comprenant des conducteurs 12 disposés en un faisceau appelé araignée TAB 13 et fixé par une couche adhésive 14 sur une face d'un substrat 15 préformé, fait en un matériau souple et électriquement isolant. Les pattes 12 de l'araignée 13 sont disposées en porte-à-faux autour d'une fenêtre 16 du substrat 15 qui a été découpé, suivant les lignes latérales tiretées de la figure 1, d'un film TAB 17 de type cinématographique. Le support 10 présente ainsi des perforations latérales 18 du film 17, qui servent au déplacement et au positionnement du support 10. Dans la fenêtre 16, les pattes 12 de l'araignée 13 sont portées par deux cadres 19, 20. Le cadre 19 s'étend sensiblement à mi-distance de la longueur en porte-à-faux des pattes 12 de l'araignée 13 dans la fenêtre 16. La fenêtre 16 et le cadre 19 ont été formés par par découpage mécanique du substrat 15 lorsqu'il ne comportait pas encore l'araignée 13. La figure 3A illustre le substrat 15 ainsi préformé. Le cadre 19 a donc la même épaisseur et le même matériau que le substrat 15 et est rattaché à lui par des bras 21 laissés lors du découpage du film 17 et alignés sur les diagonales de la fenêtre 16. La fenêtre 16a formée par les parois intérieures du cadre 19 ne comporte plus d'extension du substrat 15. Comme représenté sur la figure 2, l'araignée 13 est aussi fixée par la couche adhésive 14 au cadre 19. Le cadre 20 réunit toutes les extrémités des pattes 12 et est percé de trous 22 sous les pattes respectives 12 pour être connecté aux bornes 23 du circuit intégré 11 par l'intermédiaire de boules de brasure 24, en étain-plomb par exemple. En pratique, les boules 24 sont ordinairement formées ou fixées sur les bornes du circuit intégré 11 de type classique, puis elles sont introduites dans les trous 22 du cadre 20 comme représenté sur la figure 2. Dans la technique antérieure, le cadre 20 était similaire au cadre 19 et était donc nécessairement rattaché au cadre 19 par des bras alignés sur les diagonales du cadre 19.

Selon l'invention, le cadre 20 est un élément rapporté, dans la fenêtre 16a, sur les extrémités ILB des pattes 12, indépendant du substrat 15 et d'épaisseur sensiblement moindre que celle du substrat. Les figures 3A et 3B sont des vues similaires à celle de la figure 2, illustrant deux étapes du procédé préféré de réalisation du cadre 20 pour l'obtention d'un support 10 conforme à l'invention. Dans ces figures, le support préformé 15 a été recouvert d'une feuille métallique uni forme 13a qui servira ultérieurement à former l'araignée TAB 13. Dans la fenêtre 16a formée par le cadre 19 a été appliquée directement sur la feuille métallique uniforme 13a une couche de matériau isolant photosensible sous une forme liquide, étalée sur une épaisseur sensiblement moindre que l'épaisseur du substrat 15. Dans la pratique, du photopolyimide a été appliqué par pulvérisation sur une épaisseur de 30 micromètres alors que l'épaisseur du substrat faisait 100 micromètres. Le cadre 20 et ses trous 22, tels que représentés sur les figures 1 et 2, ont été obtenus par photogravure de la couche 26. On a procédé ensuite à la gravure de la feuille métallique 13a pour former l'araignée TAB 13. En variante, la feuille 13a pourrait être gravée avant la couche 26.

Un support 10 conforme à l'invention peut être obtenu à partir de procédés différents de celui illustré. Ce peut être d'abord une variante de ce procédé. Notamment, le photopolyimide peut être appliqué autrement que par pulvérisation. Un procédé connu est l'étalement par rotation (spin on). Ce matériau est actuellement nouveau sur le marché et n'a pas encore révélé toutes ses caractéristiques et avantages. Par exemple, la sérigraphie pourrait avantageusement s'appliquer sur l'araignée 13 déjà formée. Selon une autre variante, le matériau isolant photosensible de la couche 26 est celui utilisé normalement pour la délimitation d'une plage de soudure sur un conducteur et connu généralement sous le nom "solder resist". Pour des densités très élevées, les trous 22 pourraient être faits ultérieurement, non par photogravure de la couche 26, mais par un procédé permettant d'obtenir des trous de très faible diamètre tel qu'un percement par un faisceau laser.

Par ailleurs, le cadre 20 peut être fait non plus directement sur l'araignée comme illustré dans les figures 3A et 3B, mais à l'écart du support 10 puis rapporté sur l'araignée 13 et fixé à celle-ci. La figure 4 illustre un support TAB 10 conforme à l'invention, obtenu selon cette variante de réalisation. Dans la figure 4, l'araignée 13, le substrat 15 et le cadre 19 ont été fabriqués de manière classique, tandis que le cadre 20 a été fabriqué indépendamment, à l'écart du support 10. En pratique, on a pris une feuille mince de polyimide de 25 micromètres d'épaisseur et on l'a gravée par exposition à un plasma d'oxygène pour obtenir le cadre 20 et pour percer les trous 22. Le cadre 20 a été rapporté sur l'araignée 13 et fixé à elle par une couche adhésive 14 identique à celle collant l'araignée 13 au substrat 15.

Plusieurs variantes de ce procédé peuvent être mises en oeuvre, pour fabriquer le cadre 20 indépendamment d'un support 10 obtenu de manière classique, pour le fixer au support 10 et pour former les trous 22. Notamment, le cadre 20 peut être fixé directement à l'araignée 13, par échauffement local par ultra-sons par exemple, et les trous 22 peuvent être percés avant ou après fixation du cadre 20, par laser par exemple. Il ressort aussi à l'évidence que le cadre 20 peut être rapporté sur l'araignée 13 pendant la fabrication classique du support 10, par exemple avant la gravure de l'araignée 13 montée sur le substrat 15.

## Revendications

1. Support TAB (10) d'un circuit intégré de haute densité (11), comprenant une araignée conductrice TAB (13) qui est collée par une couche adhésive (14) sur un substrat isolant préformé (15) incluant une fenêtre (16a) pour loger le circuit intégré et qui est pourvue de pattes (12) dont les extrémités intérieures en porte-à-faux dans la fenêtre (16a) sont prévues pour leur connexion aux bornes respectives (23) du circuit intégré par l'intermédiaire de boules (24) et portent un cadre isolant (20) destiné à reposer sur le circuit intégré, ladite fenêtre (16a) ne comportant pas d'extension du substrat (15) et le cadre étant un élément rapporté sur les pattes et formé de manière à être indépendant du substrat (15) avec une épaisseur sensiblement moindre que celle du substrat.

2. Support selon la revendication 1, caractérisé en ce que le cadre (20) est fait en un matériau photosensible directement appliqué sur les pattes (12).

3. Support selon la revendication 1, caractérisé en ce que le cadre (20) est collé sous les pattes (12).

4. Support selon l'une des revendications 1 à 3, caractérisé en ce que le cadre (20) est percé sous les pattes (12) pour recevoir lesdites boules (24).

5. Support selon l'une des revendications 1 à 4, caractérisé en ce qu'il comporte ledit circuit intégré.

6. Procédé de fabrication d'un support TAB (10), comprenant la fixation, par une couche adhésive (14), d'une feuille métallique conductrice (13a) sur un substrat isolant préformé (15) et la gravure de la feuille métallique pour constituer au moins une araignée conductrice TAB (13) pourvue d'extrémités intérieures en porte-à-faux dans une fenêtre (16a) du substrat (15), ladite fenêtre étant formée sans aucune extension du substrat (15), le procédé comprenant la formation d'un cadre isolant (20) indépendamment de la fabrication du substrat isolant préformé (15) et ayant une épaisseur sensiblement moindre que l'épaisseur du substrat (15), et la fixation du cadre isolant (20) sur les extrémités intérieures de l'araignée TAB (13).

7. Procédé selon la revendication 6, caractérisé en ce que le cadre (20) étant préalablement percé de trous (22), sa fixation comprend la mise en correspondance des trous (22) avec les extrémités intérieures de l'araignée TAB (13).

8. Procédé selon la revendication 6, caractérisé en ce que le cadre ( 20) étant formé uniforme, il comporte le percement de trous (22) dans le cadre (20) sous les extrémités intérieures de l'araignée TAB (13).

9. Procédé selon la revendication 6, caractérisé en ce que la fixation du cadre (20) comprend l'application directe d'une couche de matériau isolant photosensible (26) sur la feuille métallique (13a) dans au moins la région centrale de la fenêtre (16a) sur une épaisseur sensiblement moindre que l'épaisseur du substrat (15), et la photogravure de ladite couche pour former le cadre (20) sous les extrémités intérieures de l'araignée TAB (13).

10. Procédé selon la revendication 9, caractérisé en ce que le matériau isolant photosensible (26) est appliqué par dépôt sous forme liquide sur la feuille métallique (13a).

11. Procédé selon la revendication 9 ou 10, caractérisé en ce que le matériau isolant photosensible ( 29) est du photopolyimide.

12. Procédé selon la revendication 9, 10 ou 11, caractérisé en ce que le matériau isolant photosensible (26) est du même type que celui utilisé normalement pour la délimitation des plages de soudure sur un conducteur.

13. Procédé selon l'une des revendications 9 à 12, caractérisé en ce que la photogravure comporte le percement de trous (22) dans le cadre (20) sous les extrémités intérieures de l'araignée TAB (13).

## Patentansprüche

1. TAB-Träger (10) einer hochintegrierten Schaltung (11), mit einer TAB-Leiterspinne (13), die durch eine Klebstoffschicht (14) auf ein vorgeformtes isolierendes Substrat (15), das ein Fenster (16a) zur Aufnahme der integrierten Schaltung aufweist, aufgeklebt und mit Anschlußbeinen (12) versehen ist, deren in das Fenster (16a) freitragend hineinragende Innenenden dafür vorgesehen sind, mit den entsprechenden Anschlüssen (23) der integrierten Schaltung über Lotklümpchen (24) verbunden zu werden, und einen isolierenden Rahmen (20) tragen, der dafür vorgesehen ist, auf der integrierten Schaltung aufzuliegen, wobei das Fenster (16a) keine Fortsätze des Substrats (15) aufweist und der Rahmen ein auf die Anschlußbeine aufgesetztes Element ist, das unabhängig von dem Substrat (15) mit einer Dicke gebildet ist, die wesentlich geringer als die des Substrats ist.

2. Träger nach Anspruch 1, dadurch gekennzeichnet, daß der Rahmen (20) aus einem photosensiblen Material besteht, das direkt auf die Anschlußbeine (12) aufgebracht ist.

3. Rahmen nach Anspruch 1, dadurch gekennzeichnet, daß der Rahmen (20) unterhalb der Anschlußbeine (12) angeklebt ist.

4. Träger nach einem der Ansprüche 1 bis 3, dadurch gekennzeichnet, daß der Rahmen (20) unterhalb der Anschlußbeine (12) zur Aufnahme der Lotklümpchen (24) durchbrochen ist.

5. Träger nach einem der Ansprüche 1 bis 4, dadurch gekennzeichnet, daß er die integrierte Schaltung enthält.

6. Verfahren zur Herstellung eines TAB-Trägers (10), bei dem eine leitende Metallfolie (13a) auf einem vorgeformten isolierenden Substrat (15) mittels einer Klebstoffschicht (14) befestigt wird und die Metallfolie geätzt wird, um wenigstens eine TAB-Leiterspinne (13) zu bilden, die mit in ein Fenster (16a) des Substrats (15) freitragend hineinragenden Innenenden versehen ist, wobei das Fenster ohne einen Fortsatz des Substrats (15) gebildet ist, wobei das Verfahren das Bilden eines isolierenden Rahmens (20) unabhängig von der Herstellung des vorgeformten isolierenden Substrats (15) umfaßt, wobei der Rahmen eine Dicke aufweist, die wesentlich kleiner als die Dicke des Substrats (15) ist, sowie das Befestigen des isolierenden Rahmens (20) auf den Innenenden der TAB-Spinne (13).

7. Verfahren nach Anspruch 6, dadurch gekennzeichnet, daß der Rahmen (20) im voraus von Löchern (22) durchbrochen wird, wobei zu seiner Befestigung die Löcher (22) mit den Innenenden der TAB-Spinne (13) ausgerichtet werden.

8. Verfahren nach Anspruch 6, dadurch gekennzeichnet, daß das Verfahren, wenn der Rahmen (20) gleichförmig gebildet wird, das Ausbilden der Löcher (22) in dem Rahmen (20) unter den Innenenden der TAB-Spinne (13) umfaßt.

9. Verfahren nach Anspruch 6, dadurch gekennzeichnet, daß das Befestigen des Rahmens (20) das direkte Aufbringen einer Schicht von photosensiblem isolierendem Material (26) auf die Metallfolie (13a) in wenigstens dem Mittelbereich des Fensters (16a) in einer Dicke umfaßt, die wesentlich kleiner als die Dicke des Substrats (15) ist, sowie das Photoätzen der Schicht, um den Rahmen (20) unter den Innenenden der TAB-Spinne (13) zu bilden.

10. Verfahren nach Anspruch 9, dadurch gekennzeichnet, daß das photosensible isolierende Material (26) auf die Metallfolie (13a) durch Ablagern in flüssiger Form aufgebracht wird.

11. Verfahren nach Anspruch 9 oder 10, dadurch gekennzeichnet, daß das photosensible isolierende Material (29) aus Photopolyimid besteht.

12. Verfahren nach Anspruch 9, 10 oder 11, dadurch gekennzeichnet, daß das photosensible isolierende Material (26) von gleicher Art wie das normalerweise zur Abgrenzung der Lotbereiche auf einem Leiter verwendete Material ist.

13. Verfahren nach einem der Ansprüche 9 bis 12, dadurch gekennzeichnet, daß das Photoätzen das Ausbilden der Löcher (22) in dem Rahmen (20) unter den Innenenden der TAB-Spinne (13) umfaßt.

## Claims

1. A TAB support (10) for a very large scale integrated circuit (11), comprising a TAB conducting spider (13) which is stuck by an adhesive layer (14) to a preformed insulating substrate (15) including a window (16a) for housing the integrated circuit and which is provided with tabs (12), the inner extremities of which, overhanging in the window (16a) are provided in order to connect them to the respective terminals (23) of the integrated circuit via beads (24) and have an insulated frame (20) intended to rest on the integrated circuit, said window (16a) not comprising an extension to the substrate (15) and the frame being an element mounted on the tabs and formed so as to be independent of the substrate (15) with an thickness substantially less than that of the substrate.

2. A support according to Claim 1, characterised in that the frame (20) is made of a photosensitive material applied directly to the tabs (12).

3. A support according to Claim 1, characterised in that the frame (20) is stuck on under the tabs (12).

4. A support according to one of Claims 1 to 3, characterised in that the frame (20) is perforated under the tabs (12) in order to receive said beads (24).

5. A support according to one of Claims 1 to 4, characterised in that it comprises said integrated circuit.

6. A process for manufacturing a TAB support (10), comprising the fastening, by an adhesive layer (14), of a conducting metal foil (13a) to a preformed insulating substrate (15) and the engraving of the metal foil so as to constitute at least one TAB conducting spider (13) provided with inner extremities overhanging in a window (16a) of the substrate (15), said window being formed without any extension to the substrate (15), the process comprising the formation of an insulating frame (20) independently of the manufacture of the preformed insulating substrate (15) and having a thickness substantially less than the thickness of the substrate (15), and the fastening of the insulating frame (20) to the inner extremities of the TAB spider (13).

7. A process according to Claim 6, characterised in that, the frame (20) being previously perforated with holes (22), its fastening comprises the alignment of the holes (22) with the inner extremities of the TAB spider (13).

8. A process according to Claim 6, characterised in that the frame (20) being formed so as to be uniform, it comprises the perforation of holes (22) in the frame (20) under the inner extremities of the TAB spider (13).

9. A process according to Claim 6, characterised in that the fastening of the frame (20) comprises the direct application of a layer of photosensitive insulating material (26) to the metal foil (13a) in at least the central region of the window (16a) over a thickness substantially less than the thickness of the substrate (15), and the photo-engraving of said layer to form the frame (20) under the inner extremities of the TAB spider (13).

10. A process according to Claim 9, characterised in that the photosensitive insulating material (26) is applied by deposition in liquid form to the metal foil (13a).

11. A process according to Claim 9 or 10, characterised in that the photosensitive insulating material (29) is photopolyimide.

12. A process according to Claim 9, 10 or 11, characterised in that the photosensitive insulating material (26) is of the same type as that used normally to delimit the soldering areas on a conductor.

13. A process according to one of Claims 9 to 12, characterised in that the photo-engraving comprises the perforation of holes (22) in the frame (20) under the inner extremities of the TAB spider (13).
